(19) Europäisches Patentamt
European Patent Office
Office européen des brevets

(11) **EP 1 797 634 B1**

(12) **EUROPÄISCHE PATENTSCHRIFT**

(45) Veröffentlichungstag und Bekanntmachung des Hinweises auf die Patenterteilung:
**07.07.2010 Patentblatt 2010/27**

(21) Anmeldenummer: **05773707.4**

(22) Anmeldetag: **06.08.2005**

(51) Int Cl.:
*H02P 6/08* *(2006.01)*  *H02P 6/14* *(2006.01)*
*H03K 17/0812* *(2006.01)*  *H03K 17/0814* *(2006.01)*

(86) Internationale Anmeldenummer:
**PCT/EP2005/008546**

(87) Internationale Veröffentlichungsnummer:
**WO 2006/039956 (20.04.2006 Gazette 2006/16)**

(54) **VERFAHREN UND ANORDNUNG ZUM STEUERN DER BESTROMUNG EINES ELEKTRONISCH KOMMUTIERTEN MOTORS**

METHOD AND ARRANGEMENT FOR CONTROLLING THE ELECTRICITY SUPPLY OF AN ELECTRONICALLY COMMUTATED MOTOR

PROCEDE ET DISPOSITIF DE COMMANDE DE L'ALIMENTATION EN COURANT D'UN MOTEUR A COMMUTATION ELECTRONIQUE

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **09.10.2004 DE 102004049985**

(43) Veröffentlichungstag der Anmeldung:
**20.06.2007 Patentblatt 2007/25**

(73) Patentinhaber: **ebm-papst St. Georgen GmbH & Co. KG**
**78112 St. Georgen (DE)**

(72) Erfinder: **DORNHOF, Konstantin**
**78194 Immendingen (DE)**

(74) Vertreter: **Raible, Tobias et al**
**Raible & Raible**
**Schoderstrasse 10**
**70192 Stuttgart (DE)**

(56) Entgegenhaltungen:
**US-A- 4 760 293**    **US-A1- 2002 070 772**
**US-A1- 2004 051 489**

## Beschreibung

Die Erfindung betrifft ein Verfahren und eine Anordnung zum Steuern der Bestromung von Wicklungssträngen in einem elektronisch kommutierten Motor (ECM), wie er z.B. im Dokument US 2004/0051489 beschrieben ist.

In einer Vielzahl von Anwendungen ist das Auftreten von Motorgeräuschen beim Betrieb von Elektromotoren problematisch. Derartige Motorgeräusche treten unter anderem beim Ausschalten von Wicklungssträngen in den Elektromotoren auf. Beim Betrieb von ECM, in denen bei der Kommutierung die Wicklungsstränge fortwährend ein- und ausgeschaltet werden, können derartige Motorgeräusche, welche auch als Kommutierungsgeräusche bezeichnet werden, zu einer unangenehmen Körperschallanregung führen.

Aufgabe der vorliegenden Erfindung ist es, eine neue Anordnung zum Steuern der Bestromung eines ECM bereit zu stellen. Diese Aufgabe wird durch den Gegenstand des unabhängigen Patentanspruchs 1 gelöst. Bevorzugte Ausführungsformen sind Gegenstand der abhängigen Patentansprüche.

Der Erfindung liegt die Erkenntnis zugrunde, dass insbesondere beim schnellen Ausschalten von Wicklungssträngen in einem Elektromotor Motorgeräusche entstehen. Ein Grundgedanke der Erfindung besteht deshalb darin, das Ausschalten von Wicklungssträngen in einem Elektromotor zu verlangsamen.

Insbesondere wird die Aufgabe der vorliegenden Erfindung durch einen elektronisch kommutierten Motor gemäß Anspruch 1 gelöst. Dementsprechend ist einem Wicklungsstrang in einem Elektromotor erfindungsgemäß ein Feldeffekttransistor zum Steuern des Stromes in diesem Wicklungsstrang zugeordnet. Der Feldeffekttransistor ist mit einer Quelle verbunden, an welcher ein Steuersignal zum Steuern dieses Halbleiterschalters erzeugt wird. Der Feldeffekttransistor wird zum Einschalten des zugeordneten Wicklungsstrangs durch das Steuersignal eingeschaltet und zum Ausschalten dieses Wicklungsstranges durch das Steuersignal ausgeschaltet. Hierbei wird der Ausgang der Quelle zumindest beim Ausschalten des Feldeffekttransistors auf hochohmig gesetzt. Somit kann ein schnelles Ausschalten des Feldeffekttransistors und somit des zugeordneten Wicklungsstranges über diesen Ausgang der Steuereinheit verhindert werden.

Der Elektromotor ist mit einer Mehrzahl von Wicklungssträngen ausgeführt. Jedem Wicklungsstrang ist ein Feldeffekttransistor zugeordnet, welcher mit einem entsprechenden Ausgang der Quelle verbunden ist, die dazu ausgebildet ist, dem zugeordneten Feldeffekttransistor ein entsprechendes Steuersignal bereitzustellen. Hierbei ist der Elektromotor dazu ausgebildet, zumindest beim Ausschalten eines der Feldeffekttransistoren den diesem Feldeffekttransistor zugeordneten Ausgang auf hochohmig zu setzen, um eine Beeinflussung dieses Feldeffekttransistors durch den zugeordneten Ausgang während des Ausschaltvorgangs zu verhindern.

Eine bevorzugte Weiterbildung des erfindungsgemäßen Elektromotors ist Gegenstand des Anspruchs 2. Dementsprechend wird das Steuersignal dem Feldeffekttransistor über einen zwischen dem Ausgang der Quelle und dem Halbleiterschalter angeordneten Strombegrenzungswiderstand zugeführt, um eine Überlastung des Feldeffekttransistors zu vermeiden. Da der Ausgang der Quelle zumindest beim Ausschalten dieses Feldeffekttransistors auf hochohmig gesetzt ist, kann während des Ausschaltvorgangs kein Strom zum Ausschalten des Feldeffekttransistors über den Strombegrenzungswiderstand fließen. Ein entsprechender Stromfluss wird bevorzugter Weise über einen zwischen den Steuerelektroden des Feldeffekttransistors angeordneten Ableitwiderstand abgeleitet. Dementsprechend wird der Feldeffekttransistor über diesen Ableitwiderstand ausgeschaltet.

Durch eine entsprechende Dimensionierung des Ableitwiderstands kann ein verlangsamtes Ausschalten, d.h. ein sich über eine vorgegebene Zeitdauer erstreckendes Ausschalten des Feldeffekttransistors und somit des zugeordneten Wicklungsstranges erreicht werden. Durch das verlangsamte Ausschalten des Wicklungsstranges werden auftretende Motorgeräusche reduziert, wodurch in vorteilhafter Weise eine unangenehme Körperschallanregung vermieden werden kann.

Erfindungsgemäß kann die Größe des Ableitwiderstands in Abhängigkeit von einer erforderlichen Abschaltdauer für das Abschalten des Feldeffekttransistors vorgegeben werden. Hierbei ist der Widerstand des Ableitwiderstands vorzugsweise größer als der Widerstand des Strombegrenzungswiderstands.

Eine weitere bevorzugte Weiterbildung des erfindungsgemäßen Elektromotors ist Gegenstand des Anspruchs 6. Eine Verlangsamung des Ausschaltens des Feldeffekttransistors kann durch Anordnung eines RC-Gliedes zwischen dem Gate-Anschluss und dem Drain-Anschluss des MOSFET erreicht werden. Durch eine derartige Verlangsamung können die durch den Ausschaltvorgang entstehenden Motorgeräusche weiter reduziert werden.

Eine weitere, bevorzugte Weiterbildung des erfindungsgemäßen Elektromotors ist Gegenstand des Anspruchs 7. Dementsprechend ist der Ausgang einer Quelle von Steuersignalen zumindest beim Ausschalten des zugeordneten Feldeffekttransistors als Mess-Eingang umschaltbar. Der Mess-Eingang ist vorzugsweise dazu ausgebildet, ein Rückkopplungssignal zu messen, welches den Ausschaltgrad des zugeordneten Feldeffekttransistors kennzeichnet. Hierbei kann der Quelle ein Komparator zugeordnet sein, welcher dazu ausgebildet ist, das Rückkopplungssignal mit einem Schaltschwellenwert zu vergleichen. Dieser Vergleich dient zur Bestimmung des Ausschaltgrades dieses Feldeffekttransistors und ermöglicht eine verbesserte Abstimmung von Ein- und Ausschaltvorgängen.

Bevorzugte Ausgestaltungen dieser Weiterbildung sind Gegenstände der Ansprüche 9 bis 11.

Hierbei kann beispielsweise ein Einschaltvorgang eines zweiten Wicklungsstrangs derart auf einen Ausschaltvorgang eines ersten Wicklungsstrangs des ECM abgestimmt werden, dass der zweite Wicklungsstrang im Wesentlichen erst dann eingeschaltet wird, wenn der erste Wicklungsstrang ausgeschaltet ist. Vorzugsweise wird hierzu beim Ausschaltvorgang des dem ersten Wicklungsstrang zugeordneten Feldeffekttransistors eine Spannung gemessen, bei der dieser Feldeffekttransistor ausgeschaltet ist. Für den Fall, dass der erste Feldeffekttransitstor durch einen N-Kanal MOSFET realisiert wird, kann beispielsweise die Gate-Source-Spannung gemessen werden. Wenn die Gate-Source-Spannung einen vorgegebenen Schaltschwellenwert unterschreitet, geht der N-Kanal-MOSFET in den Sperrbereich über, und der erste Feldeffekttransistor sowie der zugeordnete erste Wicklungsstrang sind ausgeschaltet. Somit ermöglicht diese bevorzugte Weiterbildung eine verbesserte Abstimmung von Ein- und Ausschaltvorgängen bei der Kommutierung in einem ECM, sowie eine Reduzierung von Kommutierungsgeräuschen.

Gegenüber bekannten Lösungsansätzen werden die beim Ausschalten von Wicklungssträngen auftretenden Motorgeräusche in Elektromotoren erfindungsgemäß mit einem geringen Materialaufwand und unter Verwendung einer einfachen Schaltung ermöglicht. Die Erfindung ist dabei nicht auf einen bestimmten Motortyp beschränkt.

Weitere Einzelheiten und vorteilhafte Weiterbildungen der Erfindung ergeben sich aus den im Folgenden beschriebenen und in den Zeichnungen dargestellten Ausführungsbeispielen. Es zeigt:

Fig. 1   ein vereinfachtes Schaltbild einer Steuerschaltung zum Steuern der Bestromung eines ersten Wicklungsstranges in einem Elektromotor gemäß der Erfindung,

Fig. 2A   eine schematische Darstellung eines an dem Ausgang der Steuereinheit aus Fig. 1 erzeugten Steuersignals und eines an dem Halbleiterschalter aus Fig. 1 erzeugten Gate- Signals,

Fig. 2B   eine schematische Darstellung des Steuersignals und des Gate-Signals aus Fig. 2A sowie einer entsprechenden Drain-Source-Spannung an dem Halbleiterschalter aus Fig. 1,

Fig. 2C   eine schematische Darstellung des in dem Wicklungsstrang aus Fig. 1 erzeugten Stroms,

Fig. 3   ein vereinfachtes Schaltbild der Steuerschaltung aus Fig. 1 gemäß einer Weiterbildung der Erfindung,

Fig. 4A   eine schematische Darstellung eines an dem Ausgang der Steuereinheit aus Fig. 3 erzeugten Steuersignals und eines an dem Halbleiterschalter aus Fig. 3 erzeugten Gate- Signals,

Fig. 4B   eine schematische Darstellung des Steuersignals und des Gate-Signals aus Fig. 4A sowie einer entsprechenden Drain-Source-Spannung an dem Halbleiterschalter aus Fig. 3,

Fig. 4C   eine schematische Darstellung des in dem Wicklungsstrang aus Fig. 3 erzeugten Stroms,

Fig. 5   ein vereinfachtes Schaltbild eines Anwendungsbeispiels für die Steuerschaltung aus Fig. 3 zum Steuern der Bestromung von Wicklungssträngen in einem ECM gemäß der Erfindung,

Fig. 6A   eine schematische Darstellung von an dem ersten und zweiten Ausgang der Steuereinheit aus Fig. 5 erzeugten Gate-Signalen,

Fig. 6B   eine schematische Darstellung von durch die Gate-Signale aus Fig. 6A bewirkten Drain- Source-Spannungen an den Halbleiterschaltern aus Fig. 5,

Fig. 6C   eine schematische Darstellung von an dem ersten und zweiten Ausgang der Steuereinheit aus Fig. 5 erzeugten steueroptimierten Gate-Signalen,

Fig. 6D   eine schematische Darstellung von durch die steueroptimierten Gate-Signale aus Fig. 6C bewirkten Drain-Source-Spannungen an den Halbleiterschaltern aus Fig. 5, und

Fig. 7   ein Flussdiagramm eines beispielhaften Verfahrens zum Steuern der Bestromung von Wicklungssträngen in einem ECM.

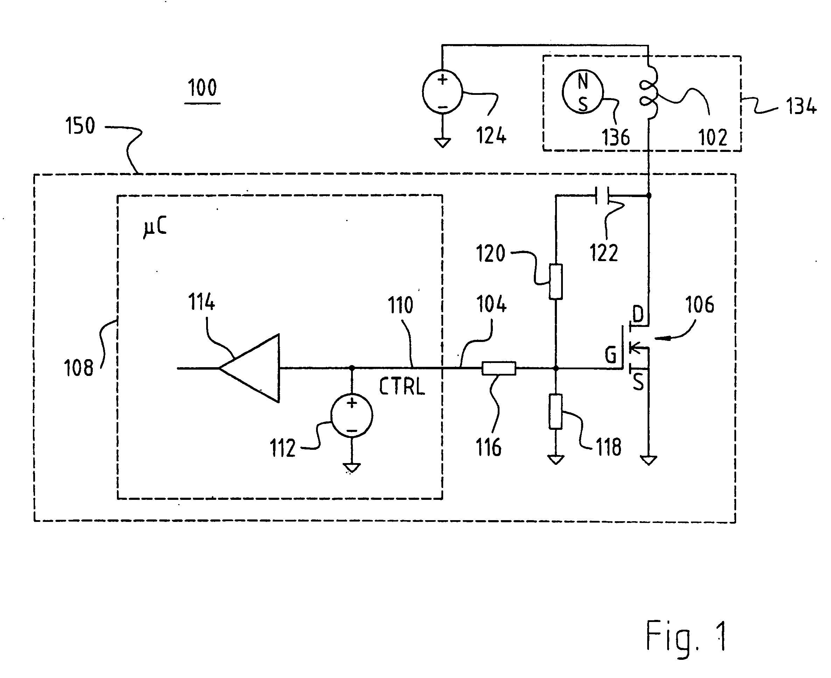

Fig. 1 zeigt ein vereinfachtes Schaltbild einer Vorrichtung 100, welche die prinzipielle Funktionsweise einer Steuerschaltung 150 gemäß der vorliegenden Erfindung illustriert. Letztere ist dazu ausgebildet, das Ausschalten eines Wicklungsstrangs 102 in einem schematisch dargestellten Elektromotor 134 zu verlangsamen. Der Elektromotor 134 hat einen Rotor 136, der als permanentmagnetischer Rotor dargestellt ist.

Die Steuerschaltung 150 weist eine Steuereinheit (µC) 108 auf, welche beispielhaft eine Steuerimpulsquelle 112 und einen Komparator 114 aufweist. Der Komparator 114 ist ausgangsseitig mit einer (nicht dargestellten) Steuerlogik der Steuereinheit 108 verbunden. Eingangsseitig ist der Komparator 114 mit dem Pluspol der Steuerimpulsquelle 112 und einem Ausgang 110 der Steuereinheit 108 verbunden. Der Ausgang 110 ist über eine Steuerleitung 104, welche einen Strombegrenzungswiderstand 116 aufweist, mit einem Halbleiterschalter verbunden.

Der Halbleiterschalter ist bei diesem Ausführungsbeispiel als Feldeffekttransistor 106 vom Typ N-Kanal MOSFET realisiert. Die Steuerleitung 104 ist an das Gate G des MOSFET 106 angeschlossen. Das Gate G des MOSFET 106 ist einerseits über einen Ableitwiderstand 118 mit Masse, und andererseits über ein RC-Glied 120, 122 mit dem Drain D des MOSFET 106 verbunden. Die Source S des MOSFET 106 ist mit Masse verbunden, sein Drain D ist über einen Wicklungsstrang 102 mit dem Pluspol eines Gleichstrom-Zwischenkreises 124 verbunden.

Im Betrieb liegt am Zwischenkreis 124 eine Versorgungsspannung für den Wicklungsstrang 102 an. Die Bestromung des Wicklungsstrangs 102 wird über den MOSFET 106 gesteuert.

Am Ausgang 110 der Steuereinheit 108 wird ein Steuersignal CTRL erzeugt und dem MOSFET 106 über die Steuerleitung 104 zugeführt.

In der in Fig. 1 dargestellten Ausführungsform wird das Steuersignal CTRL von der Steuerimpulsquelle 112 erzeugt, welche eine Steuerspannung zwischen Gate G und Source S des MOSFET 106 bewirkt. Diese Gate-Source-Spannung schaltet den MOSFET 106 ab einem vorgegebenen Schwellenwert leitend. Z.B. liegt dieser Schaltschwellenwert für MOSFETs vom Typ IRLR 3410 zwischen +1,8 V und +2 V. Wenn der MOSFET 106 leitend geschaltet ist, fließt im Wicklungsstrang 102 ein Strom von der Gleichspannungsquelle 124 über den MOSFET 106 nach Masse. Zum Ausschalten des MOSFET 106 kann das Steuersignal CTRL auf LOW gesetzt werden. Hierdurch wird das Potential am Gate G des MOSFET 106 auf LOW gezogen, so dass die Gate-Source-Spannung abgebaut wird. Dadurch fällt diese Spannung unter den Schaltschwellenwert, und der MOSFET 106 sperrt.

Der Ausschaltvorgang wird durch die Drain-Gate-Kapazität des MOSFET 106 verlangsamt. Im vorliegenden Fall wird eine zusätzliche Verlangsamung durch das RC-Glied zwischen Gate G und Drain D des MOSFET 106 erreicht.

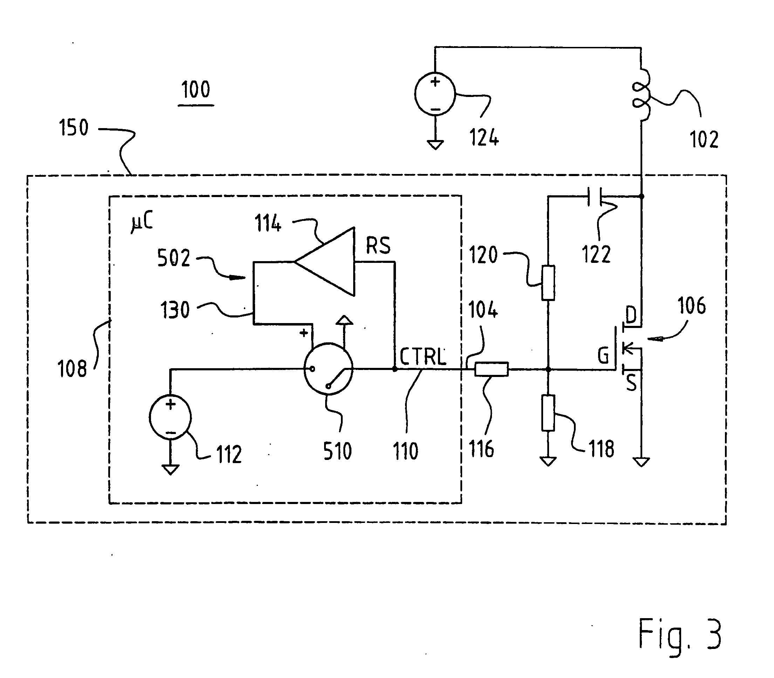

Um den Ausschaltvorgang weiter zu verlangsamen, schaltet bei der vorliegenden Anordnung die Steuereinheit 108 den Ausgang 110 beim Ausschalten des MOSFET 106 auf hochohmig. Der Ausgang 110 ist gemäß einer bevorzugten Ausführungsform der vorliegenden Erfindung in einen Mess-Eingang umschaltbar, wie in Fig. 1 durch den Komparator 114 angedeutet ist. Eine entsprechende Ausführung wird weiter unten bei Fig. 3 erläutert.

Wenn der Ausgang 110 auf hochohmig gesetzt ist, kann der Strom, welcher beim Abbauen der Gate-Source-Spannung entsteht, nicht über den Strombegrenzungswiderstand 116 und den Ausgang 110 fließen. Vielmehr fließt dieser Strom über den Ableitwiderstand 118 nach Masse. Durch eine entsprechende Dimensionierung des Ableitwiderstands 118 kann eine Verlangsamung des Ausschaltvorganges erreicht werden. Dabei wird die Größe des Ableitwiderstands 118 in Abhängigkeit von einer gewünschten Abschaltdauer des MOSFET 106 gewählt. Der Widerstand des Ableitwiderstands 118 ist vorzugsweise größer als der Widerstand des Strombegrenzungswiderstands 116. Durch das verlangsamte Ausschalten des MOSFET 106 können die Motorgeräusche reduziert werden.

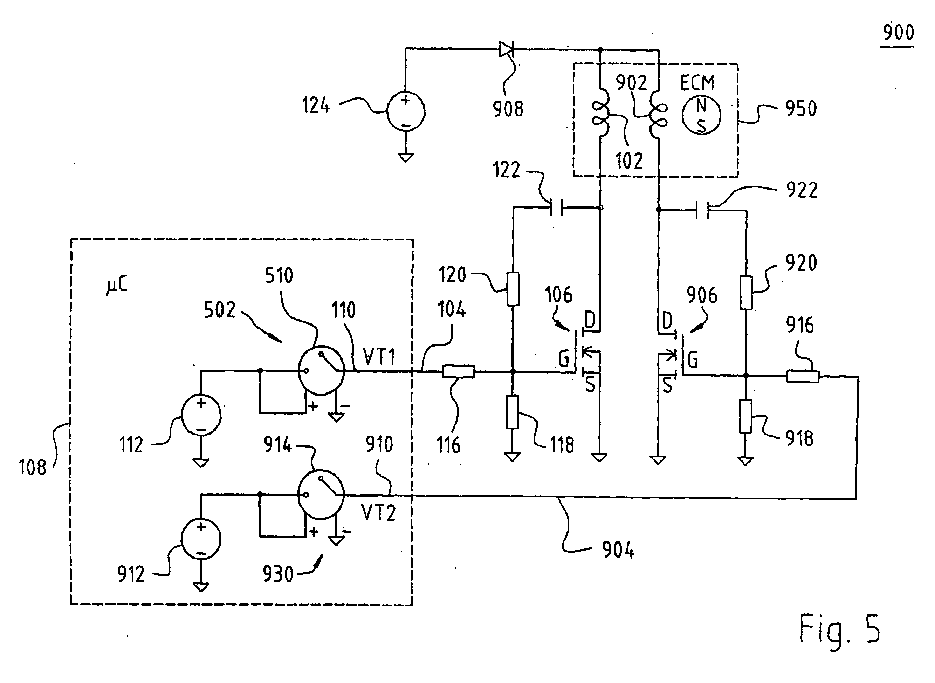

Die erfindungsgemäße Steuerschaltung 150 kann vorteilhaft in einem ECM mit einer Mehrzahl von Wicklungssträngen verwendet werden. Hierbei wird jedem Wicklungsstrang eine entsprechende Steuerschaltung zugeordnet, wobei beispielsweise anstelle einer Mehrzahl von Steuereinheiten eine entsprechende Anzahl von Ausgängen an einem einzigen Mikrocontroller verwendet werden kann. Jeder dieser Ausgänge wird hierbei wie oben stehend beschrieben konfiguriert. Ein Anwendungsbeispiel der Steuerschaltung 150 in einem zweisträngigen ECM wird unter Bezugnahme auf Fig. 5 erläutert.

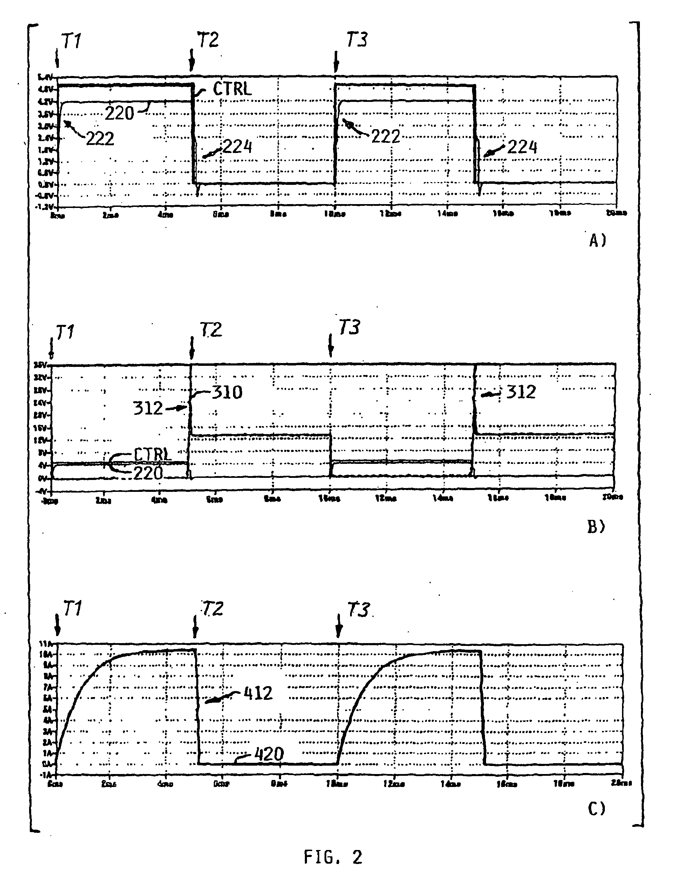

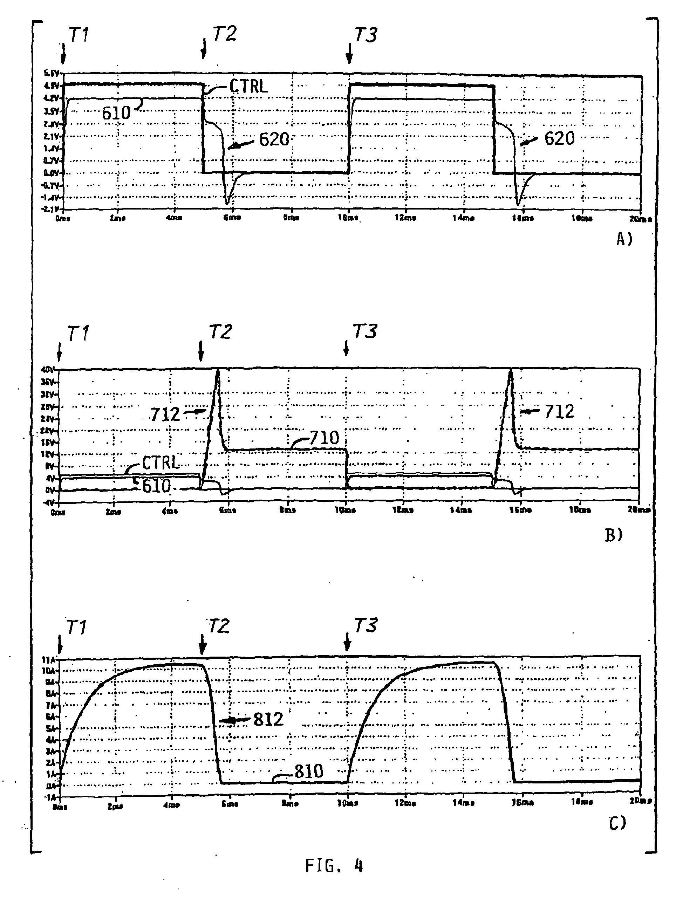

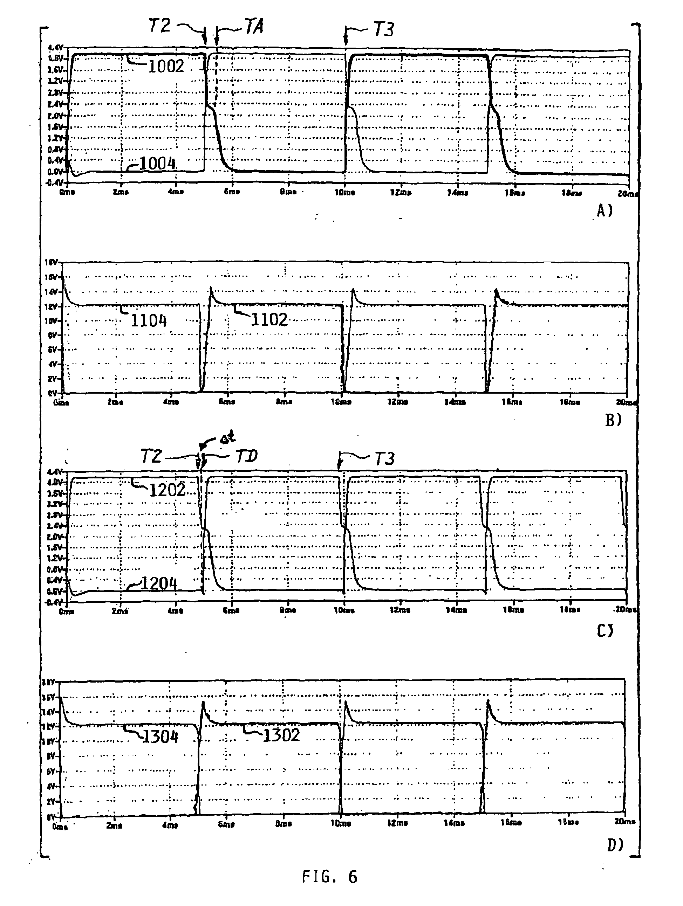

Fig. 2A zeigt Schaltvorgänge gemäß dem Stand der Technik, und zwar zeitliche Verläufe des Steuersignals CTRL aus Fig. 1 und eines Gate-Signals 220, welches die von dem Steuersignal CTRL bewirkte Gate-Source-Spannung am MOSFET 106 repräsentiert. Zur Verdeutlichung der Erfindung zeigt Fig. 2A das Gate-Signal bei Ein- und Ausschaltvorgängen, welche ausgeführt werden, ohne den Ausgang 110 auf hochohmig zu setzen oder als Mess-Eingang umzuschalten. Schematische Darstellungen von Signalverläufen bei Ein- und Ausschaltvorgängen, in welchen der Ausgang 110 während entsprechender Ausschaltvorgänge auf hochohmig gesetzt wird und/oder als Mess-Eingang betrieben wird, werden unten stehend unter Bezugnahme auf die Fig. 4 und 6 näher erläutert.

Gemäß Fig. 2A wird das Steuersignal CTRL an einem Zeitpunkt T1 beispielhaft auf +5 V gesetzt, um den MOSFET 106 einzuschalten. Hierbei wird ein Gate-Potenzial 220 von +4,2 V am MOSFET 106 erzeugt, wodurch dieser leitend geschaltet wird. Der Einschaltvorgang wird durch die Drain-Gate-Kapazität des MOSFET 106 sowie das durch den Widerstand 120 und den Kondensator 122 gebildete RC-Glied verlangsamt, vgl. die Einschaltflanke 222. Zum Ausschalten an einem Zeitpunkt T2 wird das Steuersignal CTRL auf 0 V gesetzt. Das Gate-Signal 220 folgt dem Steuersignal CTRL und fällt auf 0 V, wodurch der MOSFET 106 sperrt. Der Ausschaltvorgang wird ebenfalls durch die Drain-Gate-Kapazität des MOSFET 106 und das RC-Glied verlangsamt, vgl. die Ausschaltflanke 224.

An einem Zeitpunkt T3 wird dann das Steuersignal CTRL erneut auf +5 V gesetzt und die oben beschriebenen Vorgänge wiederholen sich.

Fig. 2B zeigt eine schematische Darstellung 300 eines Verlaufs der Drain-Source-Spannung 310 in dem MOSFET 106 aus Fig. 1, welche in Reaktion auf das Gate-Signal 220 aus Fig. 2A erzeugt wird. Zur Verdeutlichung sind das Steuersignal CTRL und das Gate-Signal 220 aus Fig. 2A ebenfalls in Fig. 2B dargestellt. Es wird jedoch darauf hingewiesen, dass die Spannungsachsen in den Diagrammen aus Fig. 2A und 2B unterschiedliche Skalierungen aufweisen, während die Zeitachsen identisch sind.

Wie Fig. 2B zeigt, beträgt die Drain-Source-Spannung 310 solange 0 V, wie der MOSFET 106 eingeschaltet ist und ein Strom durch ihn fließen kann, d.h. vom Zeitpunkt T1 bis zum Zeitpunkt T2. Beim Ausschalten des MOSFET 106 am Zeitpunkt T2 entsteht eine Drain-Source-Spannung 310, welche bis zum vollständigen Ausschalten des MOSFET 106 auf einen MOSFET-spezifischen Maximalwert ansteigt und anschließend auf einen von dem entsprechenden MOSFET abhängigen Normalwert absinkt und auf diesem Normalwert bis zum nächsten Einschalten des MOSFET 106 im Wesentlichen konstant verläuft. Illustrativ entsteht eine Spannungsspitze von annähernd +36 V, welche auf einen Normalwert von ungefähr +13 V absinkt. Je schneller der Ausschaltvorgang des MOSFET 106 ist, umso kürzer und somit steiler wird eine hierbei entstehende Spannungsspitze 312.

Wenn an dem Zeitpunkt T3 das Steuersignal CTRL erneut auf +5 V gesetzt wird, sinkt die Drain-Source-Spannung 310 wieder auf 0V ab, da der MOSFET 106 erneut leitend geschaltet wird, und sich die beschriebenen Vorgänge wiederholen.

Fig. 2C zeigt beispielhaft den Verlauf des Stroms 410 in dem Wicklungsstrang 102 aus Fig. 1, welcher beim Ein- und Ausschalten des MOSFET 106 durch das Steuersignal CTRL aus Fig. 2A erzeugt wird. Illustrativ steigt der Strom 410 in dem Wicklungsstrang 102 ab dem Zeitpunkt T1, an welchem der MOSFET 106 eingeschaltet wird, bis auf einen Maximalwert an, welcher u.a. durch die Spannung am Zwischenkreis 124 vorgegeben wird. Illustrativ liegt dieser Maximalwert im vorliegenden Beispiel bei ungefähr +10,5 A. Beim Ausschalten des MOSFET 106 am Zeitpunkt T2 wird der Stromfluss im Strang 102 unterbrochen und fällt dementsprechend auf 0 A ab. Hierbei entsteht eine Wicklungs-spezifische Ausschaltflanke 412.

Der in Fig. 2C illustrierte Verlauf entspricht im Wesentlichen der sogenannten "Sägezahnkurve", welche generell einen Spulenstrom beim Ein- und Ausschalten einer Spule charakterisiert. Je steiler hierbei die Ausschaltflanke 412 ist, umso lauter wird das Motorgeräusch.

Wenn an dem Zeitpunkt T3 das Steuersignal CTRL erneut auf +5 V gesetzt wird, steigt der Strom 412 im Strang 102 wieder an, da der MOSFET 106 erneut leitend geschaltet wird, und die beschriebenen Vorgänge wiederholen sich.

Fig. 3 zeigt ein vereinfachtes Schaltbild einer bevorzugten Ausführungsform der Erfindung, in welcher der Ausgang 110 während dem Ausschaltvorgang des MOSFET 106 als Mess-Eingang betrieben wird. Hierbei verwendete gleiche bzw. gleich wirkende Bauelemente wie in Fig. 1 sind mit den gleichen Bezugszeichen versehen und werden nicht nochmals erläutert.

Der Mess-Eingang wird in der Steuereinheit 108 der Fig. 3 mit einem Messglied 502 realisiert. Das Messglied 502 umfasst beispielhaft den Komparator 114 und ein Stellglied 510. Hierbei sind der Ausgang 110 sowie der Pluspol der Steuerimpulsquelle 112 mit dem Stellglied 510 verbunden. Der Ausgang 110 ist ferner mit einem Eingang des Komparators 114 verbunden, dessen Ausgang 130 mit einem positiven Anschluss des Stellgliedes 510 verbunden ist.

Im Betrieb dient der Mess-Eingang dazu, ein Rückkopplungssignal RS zu messen, welches den Ausschaltgrad des MOSFET 106 kennzeichnet. Hierbei ist der Komparator 114 dazu ausgebildet, das Rückkopplungssignal RS mit einem Schaltschwellenwert zu vergleichen. Dieser Schaltschwellenwert wird dem Komparator 114 beispielsweise als Schwellenspannung von einer (nicht gezeigten) Bezugsspannungsquelle zugeführt.

In dem in Fig. 3 dargestellten Beispiel ist das Rückkopplungssignal RS die Gate-Source-Spannung und der Schaltschwellenwert ist derjenige Wert, bei welchem der MOSFET 106 vom leitenden in den sperrenden Betrieb übergeht. Wie beschrieben, liegt der Schaltschwellenwert für MOSFETs vom Typ IRLR3410 zwischen +1,8 V und +2 V. Somit dient der Mess-Eingang im vorliegenden Beispiel dazu, zu messen, wann die Gate-Source-Spannung einen Wert von weniger als +2 V bis +1,8 V erreicht, durch Vergleichen der Gate-Source-Spannung mit dem Schaltschwellenwert. Hierbei kann der Ausschaltgrad bestimmt werden, welcher beispielsweise eine Abweichung der gemessenen Gate-Source-Spannung von dem Schaltschwellenwert angibt. Diese Bestimmung des Ausschaltgrades des MOSFET 106 ermöglicht eine verbesserte Abstimmung von Ein- und Ausschaltvorgängen des Wicklungsstranges 102. Ein Anwendungsbeispiel für eine Steuereinheit, in welcher ein Ausgang als Mess-Eingang umgeschaltet wird, wird unten bei Fig. 5 näher erläutert.

Fig. 4A zeigt beispielhafte zeitliche Verläufe des Steuersignals CTRL aus Fig: 1 bzw. 3 und eines Gate-Signals 610, welches die von dem Steuersignal CTRL bewirkte Gate-Source-Spannung an dem MOSFET 106 aus Fig. 1 bzw. 3 bei Ausschaltvorgängen repräsentiert, bei welchen der Ausgang 110 auf hochohmig gesetzt wird, unabhängig davon, ob der Ausgang 110 als Mess-Eingang betrieben wird oder nicht. Schematische Darstellungen von Signalverläufen bei Ein- und Ausschaltvorgängen, in welchen der Ausgang 110 während der Ausschaltvorgänge auf hochohmig gesetzt und als Mess-Eingang betrieben wird, um eine verbesserte Abstimmung von Ein- und Ausschaltvorgängen des Wicklungsstrangs 102 mit Ein- und Ausschaltvorgängen anderer Wicklungsstränge zu ermöglichen, werden bei Fig.6C bis 6D näher erläutert.

In dem in Fig. 4A dargestellten Beispiel entsprechen der zeitliche Verlauf des Steuersignals CTRL und des Gate-Signals 610 in dem Zeitintervall von T1 bis T2 dem in Fig. 2A dargestellten zeitlichen Verlauf dieser Signale in dem gleichen Zeitintervall und werden nicht nochmals erläutert.

Am Zeitpunkt T2, an welchem bei Fig. 1 das Steuersignal CTRL auf 0 V gesetzt wird, um den MOSFET 106 auszuschalten, wird bei Fig. 3 der Ausgang 110 der Steuereinheit 108 auf hochohmig gesetzt, so dass das Gate-Signal 220 verlangsamt abgebaut wird, wie aus der Ausschaltflanke 620 ersichtlich ist. Hierbei sinkt das Gate-Signal ebenfalls auf weniger als +2 V, wodurch der MOSFET 106 gesperrt wird.

Der Ausschaltvorgang wird einerseits durch die Drain-Gate-Kapazität des MOSFET 106 und das RC-Glied 120, 122, andererseits durch den hochohmigen Ausgang 110 verlangsamt. Wie oben beschrieben, wird die Gate-Source-Spannung des MOSFET 106 bei Fig. 3 nicht über den Widerstand 116 und den Ausgang 110 abgebaut, da der Ausgang 110 beim Abschalten auf hochohmig gesetzt ist. Vielmehr fließt ein durch die Gate-Source-Spannung bewirkter Strom über den Ableitwiderstand 118. Falls der Widerstand des Strombegrenzungswiderstands 116 10 k beträgt und der Widerstand des Ableitwiderstands 118 51 k, wird die Gate-Source-Spannung gemäß Fig. 4A ungefähr 5-mal langsamer abgebaut als in Fig. 2A, wo die Gate-Source-Spannung über den Strombegrenzungswiderstand 116 und den Ausgang 110 abgebaut wird. Der MOSFET 106 wird dementsprechend in dem vorliegenden Beispiel 5-mal langsamer ausgeschaltet, wenn der Ausgang 110 während des Ausschaltvorgangs auf hochohmig gesetzt wird.

Am Zeitpunkt T3 wird das Steuersignal CTRL wie oben bei Fig. 2A beschrieben erneut auf +5 V gesetzt, und die beschriebenen Vorgänge wiederholen sich.

Fig. 4B zeigt schematisch den zeitlichen Verlauf der Drain-Source-Spannung 710 in dem MOSFET 106 aus Fig. 3, welche in Reaktion auf das Gate-Signal 610 aus Fig. 4A erzeugt wird. Zur Verdeutlichung sind das Steuersignal CTRL und das Gate-Signal 610 aus Fig. 4A ebenfalls in Fig. 4B dargestellt. Es wird jedoch darauf hingewiesen, dass die Spannungsachsen in den Diagrammen der Fig. 4A und 4B unterschiedliche Skalierungen aufweisen.

Der Verlauf der Drain-Source-Spannung 710 entspricht im Wesentlichen dem Verlauf der Drain-Source-Spannung 310 aus Fig. 2B und wird daher nicht nochmals erläutert. Es wird jedoch darauf hingewiesen, dass die Spannungsspitze 712 im Gegensatz zu der Spannungsspitze 312 breiter ist, d.h. zeitlich gedehnt wird. Dies bedeutet, dass die Drain-Source-Spannung in dem vorliegenden Beispiel mehr Zeit benötigt, um nach dem Umschalten des Ausgangs 110 auf hochohmig den Maximalwert zu erreichen, und ebenso mehr Zeit, um von diesem Maximalwert auf den Normalwert von ungefähr +13 V abzufallen.

Fig. 4C zeigt schematisch den Verlauf des Stroms 810 in dem Wicklungsstrang 102 aus Fig. 3, welcher beim Ein- und Ausschalten des MOSFET 106 unter Verwendung des Steuersignals CTRL aus Fig. 4A erzeugt wird. Der zeitliche Verlauf des Stroms 810 in dem Wicklungsstrang 102 entspricht im Wesentlichen dem zeitlichen Verlauf des Stroms 410 aus Fig. 2C und wird deshalb nicht nochmals erläutert. Es wird jedoch darauf hingewiesen, dass die Ausschaltflanke 812 im Gegensatz zu der Abschaltflanke 412 der Fig. 2C langsamer abfällt, d.h., dass der Wicklungsstrang 102 langsamer ausgeschaltet wird, wie oben unter Bezugnahme auf Fig. 4A bereits erläutert wurden. Hierdurch werden die beim Ausschalten auftretenden Motorgeräusche reduziert.

Fig. 5 zeigt ein vereinfachtes Schaltbild einer Anordnung 900, in welcher die Vorrichtung 100 gemäß Fig. 3 Anwendung findet. Gleiche bzw. gleich wirkende Bauelemente wie in Fig. 3 sind mit den gleichen Bezugszeichen versehen und werden nicht nochmals erläutert.

Im Gegensatz zu Fig. 3 ist der Wicklungsstrang 102 in der Vorrichtung 900 zum Verpolschutz mit der Kathode einer Diode 908 verbunden, deren Anode mit dem Zwischenkreis 124 verbunden ist, z.B. einer Batterie oder einem Netzteil. Die Kathode der Diode 908 ist auch mit einem Ende eines Wicklungsstrangs 902 verbunden. Das andere Ende des Wicklungsstrangs 902 ist mit einem dem Wicklungsstrang 902 zugeordneten Halbleiterschalter verbunden, nämlich dem Drain D eines N-Kanal MOSFET 906. Der Drain D des MOSFET 906 ist auch über ein RC-Glied 920, 922 mit dem Gate G des MOSFET 906 verbunden. Das Gate G des MOSFET 906 ist ferner über eine Steuerleitung 904, welche einen Strombegrenzungswiderstand 916 aufweist, mit einem dem MOSFET 906 zugeordneten Ausgang 910 der Steuereinheit 108, und andererseits über einen Ableitwiderstand 918 mit Masse verbunden. Die Source S des MOSFET 906 ist ebenfalls mit Masse verbunden.

Analog zu dem Ausgang 110 ist der Ausgang 910 ebenfalls als Mess-Eingang umschaltbar und kann somit während des Ausschaltvorgangs des MOSFET 906 als hochohmiger Mess-Eingang betrieben werden. Der Aufbau der Ausgänge 110 und 910 ist im Gegensatz zu der Darstellung in Fig. 3 vereinfacht dargestellt. Dementsprechend wird dieser Mess-Eingang mit einem Messglied 930 realisiert, welches beispielhaft ein Stellglied 914 umfasst. Der Aufbau des als Mess-Eingang umschaltbaren Ausgangs 910 entspricht dem des Ausgangs 110.

In der Anordnung 900 repräsentieren die Wicklungsstränge 102 und 902 illustrativ die Statorwicklungen eines zweisträngigen ECM 950, dessen Rotor mit 960 bezeichnet ist. Die Steuereinheit 108 dient zur Kommutierung dieser Wicklungsstränge, wobei jeder einzelne Wicklungsstrang so angesteuert wird, wie unter Bezugnahme auf die Fig. 1 bzw. 3 erläutert wurde.

Im Betrieb wird jeder der Ausgänge 110 und 910 beim Ausschaltvorgang als Mess-Eingang betrieben. Dies ermöglicht eine verbesserte Abstimmung von Ein- und Ausschaltvorgängen der Wicklungsstränge 102 und 902 bei der Kommutierung in dem ECM 950, sowie eine Reduzierung von auftretenden Kommutierungsgeräuschen, wie unter Bezugnahme auf die Fig. 6 näher erläutert wird.

Fig. 6A zeigt zeitliche Verläufe eines ersten Gate-Signals 1002, welches die Gate-Source-Spannung an dem MOSFET 106 aus Fig. 5 repräsentiert, und eines zweiten Gate-Signals 1004, welches die Gate-Source-Spannung an dem MOSFET 906 aus Fig. 5 repräsentiert. Hierbei werden die MOSFETs 106 und 906 abwechselnd ein- und ausgeschaltet, d.h. der MOSFET 906 wird eingeschaltet, wenn der MOSFET 106 ausgeschaltet wird und umgekehrt.

Zur Verdeutlichung illustriert Fig. 6A zunächst Ausschaltvorgänge, bei welchen die Ausgänge 110 bzw. 910 auf hochohmig gesetzt werden, unabhängig von einem Betrieb dieser Ausgänge als Mess-Eingänge. Hierbei entspricht der zeitliche Verlauf des Gate-Signals 1002 bzw. 1004 im Wesentlichen dem in Fig. 4A dargestellten zeitlichen Verlauf des Gate-Signals 610, wobei die Spannungsachsen sowie die Zeitachsen in den Fig. 4A und 6A identisch Skalierungen aufweisen. Geringfügige Unterschiede zwischen den zeitlichen Verläufen in Fig. 4A und 6A ergeben sich durch das Auftreten von Rückkopplungseffekten zwischen den Wicklungssträngen 102 und 902 des ECM 950 und sind im Rahmen der vorliegenden Erfindung vernachlässigbar. Deshalb werden die zeitlichen Verläufe der Gate-Signale 1002 und 1004 nicht nochmals erläutert.

Es wird jedoch darauf hingewiesen, dass an dem Zeitpunkt T2, an dem der MOSFET 106 ausgeschaltet wird, gleichzeitig der MOSFET 906 eingeschaltet wird. Unter der Annahme, dass der MOSFET 106 im dargestellten Beispiel erst dann vollständig ausgeschaltet ist, wenn das Gate-Signal bzw. die Gate-Source-Spannung unter den Schaltschwellenwert von +2 V gesunken ist, ist aus Fig. 6A ersichtlich, dass der MOSFET 106 erst ab dem Zeitpunkt TA effektiv ausgeschaltet ist. Da der MOSFET 906 jedoch bereits am Zeitpunkt T2 eingeschaltet wird, werden die Wicklungsstränge 102 und 902 des ECM 950 zwischen T2 und TA gleichzeitig bestromt, was unerwünscht ist und den Wirkungsgrad reduziert.

Um dies zu vermeiden, werden die Ein- und Ausschaltvorgänge dieser Wicklungsstränge bei der Kommutierung durch Messen der entsprechenden Ausschaltgrade aufeinander abgestimmt, wie unten stehend bei Fig. 6C und 6D näher erläutert wird.

Am Zeitpunkt T3 wird der MOSFET 906 ausgeschaltet und der MOSFET 106 wird wie oben beschrieben wieder eingeschaltet, wobei sich die beschriebenen Vorgänge wiederholen.

Fig. 6B zeigt den zeitlichen Verlauf der Drain-Source-Spannung 1102 in dem MOSFET 106 aus Fig. 5, welche in Reaktion auf das Gate-Signal 1002 aus Fig. 6A entsteht, sowie der Drain-Source-Spannung 1104 in dem MOSFET 906 aus Fig. 5, welche in Reaktion auf das Gate-Signal 1004 aus Fig. 6A entsteht. Der Verlauf der Drain-Source-Spannung 1102 bzw. 1104 entspricht im Wesentlichen dem Verlauf der Spannung 710 aus Fig. 4B, unter Berücksichtigung von eventuell auftretenden Rückkopplungseffekten in den zugeordneten Wicklungssträngen 102 bzw. 902, wie bei Fig. 6A beschrieben wurde.

Fig. 6C zeigt die zeitlichen Verläufen eines ersten Gate-Signals 1202 und eines zweiten Gate-Signals 1204 gemäß einer bevorzugten Ausführungsform der vorliegenden Erfindung. Das erste Gate-Signal 1202 ist die Gate-Source-Spannung an dem MOSFET 106 aus Fig. 5, und das zweite Gate-Signal 1204 ist die Gate-Source-Spannung an dem MOSFET 906 aus Fig. 5. Wie in Fig. 6A werden auch hier die MOSFET 106 und 906 abwechselnd ein- und ausgeschaltet.

Fig. 6C zeigt die Gate-Signale bei Ausschaltvorgängen, bei welchen die Ausgänge 110 und 910 auf hochohmig gesetzt und als Mess-Eingänge betrieben werden. Hierbei werden die Ausschaltgrade der MOSFET 106 und 906 ermittelt und zur Steuerung der Schaltvorgänge dieser MOSFETs verwendet.

In Fig. 6C entsprechen die Verläufe der Gate-Signale 1202 und 1204 im Wesentlichen den zeitlichen Verläufen der Gate-Signale 1002 und 1004 aus Fig. 6A, welche jedoch in Fig. 6C zeitlich versetzt dargestellt sind. Dementsprechend wird an dem Zeitpunkt T2, an welchem der MOSFET 106 ausgeschaltet wird, der MOSFET 906 noch nicht eingeschaltet. Vielmehr wird der Einschaltvorgang des MOSFET 906 zeitverzögert um eine Dauer $\Delta t$ und erfolgt somit zu einem Zeitpunkt TD = T2 + $\Delta t$.

Gemäß einer bevorzugten Ausführungsform der vorliegenden Erfindung beträgt die Zeitverzögerung etwa

$$\Delta t = 0{,}2 \ldots 0{,}25 \times t\_Aus \qquad \ldots(1)$$

Hierbei ist t_Aus die Zeitdauer, welche bei einem vorgegebenen Typ von MOSFET benötigt wird, um die Gate-Source-Spannung von dem Maximalwert auf den Schaltschwellenwert abzubauen. Im vorliegenden Beispiel ist dies beispielsweise die Zeitdauer, die erforderlich ist, um am MOSFET 106 die maximale Gate-Source-Spannung von +4,2 V auf ungefähr +2 V abzubauen. Die Zeitdauer t_Aus kann durch Probemessungen präzisiert werden. Sie ergibt sich aus den Widerständen R116, z.B. 10 k, und R118, z.B. 51 k, nach der überschlägigen Formel

$$\Delta t = R116/R118 * t\_Aus \qquad \qquad ...(2)$$

Für die angegebenen Widerstandswerte ergibt sich daraus

$$\Delta t = 10/51* t\_Aus = 0,2 * t\_Aus \qquad \qquad ...(3)$$

Fig. 6D zeigt den zeitlichen Verlauf der Drain-Source-Spannung 1302 in dem MOSFET 106 aus Fig. 5, welche in Reaktion auf das Gate-Signal 1202 aus Fig. 6A erzeugt wird, sowie der Drain-Source-Spannung 1304 des MOSFET 906 aus Fig. 5, welche in Reaktion auf das Gate-Signal 1204 aus Fig. 6A erzeugt wird. Der zeitliche Verlauf der Drain-Source-Spannungen 1302 und 1304 entspricht im Wesentlichen dem zeitlichen Verlauf der Drain-Source-Spannungen 1102 und 1104 aus Fig. 6B, welche in Fig. 6D entsprechend der bei Fig. 6C beschriebenen Zeitverzögerung ebenfalls zeitlich versetzt zueinander verlaufen.

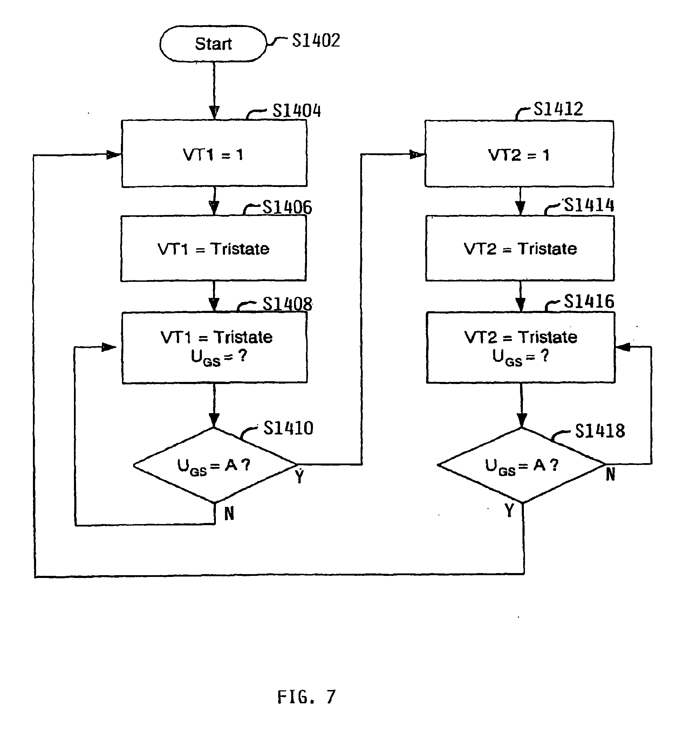

Fig. 7 zeigt ein Flussdiagramm eines beispielhaften Verfahrens zum Steuern der Bestromung der Wicklungsstränge eines Elektromotors. Zur Illustration ist es als Verfahren zum Steuern der Bestromung der beiden Wicklungsstränge 102 und 902 des ECM 950 der Fig. 5 dargestellt. Das Verfahren 1400 beginnt in Schritt S1402.

In Schritt S1404 wird ein erster Ausgang VT1 einer Steuereinheit (z.B. Ausgang 110 der Steuereinheit 108 aus Fig. 5) als Ausgang betrieben und ein erstes Steuersignal VT1 = 1 zum Einschalten eines ersten Halbleiterschalters (z.B. MOSFET 106 aus Fig. 5) wird an diesem Ausgang erzeugt. Das erste Steuersignal wird dem ersten Halbleiterschalter zugeführt, welcher somit eingeschaltet wird und einen Stromfluss in einem zugeordneten ersten Wicklungsstrang (z.B. Wicklungsstrang 102 aus Fig. 5) erzeugt.

In Schritt S1406 wird VT1 auf hochohmig (Tristate) gesetzt und umgeschaltet, um im Folgenden als Mess-Eingang betrieben zu werden.

In Schritt 51408 wird an diesem Mess-Eingang der Ausschaltgrad des ersten Halbleiterschalters 106 durch Messung der Spannung $U_{GS}$ ermittelt. In Schritt S1410 bestimmt die Steuereinheit, ob

$$U_{GS} = A \qquad ...(4)$$

ist, also ob die ermittelte Spannung $U_{GS}$ einem vorgegebenen Ausschaltgrad A entspricht, bei dem der erste Halbleiterschalter 106 ausgeschaltet ist.

In einer Ausführungsform ist der vorgegebene Ausschaltgrad A erreicht, wenn seit dem Zeitpunkt der Initiierung des Ausschaltens (z.B. Zeitpunkt T2 in Fig. 6C) eine oben bei Fig. 6C beschriebene Zeitdauer $\Delta t = 0,25$ x t_Aus vergangen ist.

Wenn der erforderliche Ausschaltgrad A noch nicht erreicht ist, wird der erste Ausgang VT1 weiterhin als Mess-Eingang betrieben und das Programm kehrt zu Schritt S1408 zurück. Wenn der erforderliche Ausschaltgrad A erreicht ist, geht das Programm zu Schritt S1412.

In Schritt S1412 wird ein zweiter Ausgang VT2 der Steuereinheit (z.B. Ausgang 910 der Steuereinheit 108 aus Fig. 5) als Ausgang betrieben und ein zweites Steuersignal VT2 =1 zum Einschalten des MOSFET 906 aus Fig. 5 wird an VT2 erzeugt und diesem MOSFET zugeführt, welcher somit eingeschaltet wird und einen Stromfluss im Wicklungsstrang 902 erzeugt.

In Schritt S1414 wird VT2 auf hochohmig (Tristate) umgeschaltet, um im Folgenden als Mess-Eingang betrieben zu werden.

In Schritt S1416 wird an diesem Mess-Eingang die Spannung $U_{GS}$ am MOSFET 906 wie oben beschrieben ermittelt. In Schritt S1418 bestimmt die Steuereinheit, ob die ermittelte Spannung $U_{GS}$ einem vorgegebenen Ausschaltgrad A entspricht. Wenn der erforderliche Ausschaltgrad A noch nicht erreicht ist, wird der zweite Ausgang weiterhin als Mess-Eingang betrieben und das Programm kehrt zum Schritt S1416 zurück. Wenn der erforderliche Ausschaltgrad A erreicht ist, geht das Programm zurück zu Schritt S1404.

Es wird darauf hingewiesen, dass der erste Ausgang VT1 und zweite Ausgang VT2 jeweils solange auf hochohmig gesetzt sein und als Mess-Eingang betrieben werden können, bis an dem entsprechenden Ausgang ein neuer Einschaltvorgang für den zugeordneten Halbleiterschalter initiiert wird. Das Programm gemäß Fig. 7 beginnt bei der Inbetriebnahme des ECM 950 und wird solange fortgeführt, wie der ECM betrieben wird, um Kommutierungsgeräusche zu reduzieren und die Abstimmung von Ein- und Ausschaltvorgängen bei der Kommutierung zu verbessern.

Abwandlungen und Modifikationen sind möglich im Rahmen der angehängten Ansprüche.

**Patentansprüche**

1. Elektronisch kommutierter Motor, welcher aufweist:

   Einen permanentmagnetischen Rotor (960);
   einen Stator mit einem ersten Wicklungsstrang (102), welchem ein erster Feldeffekttransistor (106) zugeordnet ist, der dazu dient, gesteuert von einem Potenzial an einer Steuerelektrode (G), im Betrieb den Strom durch den ersten Wicklungsstrang (102) zu steuern;
   einen zweiten Wicklungsstrang (902), welchem ein zweiter Feldeffekttransistor (906) zugeordnet ist, der dazu dient, gesteuert von einem Potenzial an einer Steuerelektrode (G) im Betrieb den Strom durch den zweiten Wicklungsstrang (102) zu steuern, wobei, gesteuert durch Kommutierungsvorgänge, der erste Feldeffekttransistor (106) und der zweite Feldeffekttransistor (906) im Betrieb alternierend eingeschaltet werden;
   eine erste Quelle (112, 510) von Steuersignalen (VT1, 1202) zur Steuerung des ersten Feldeffekttransistors (106);
   eine zweite Quelle (912, 914) von Steuersignalen (VT2, 1204) zur Steuerung des zweiten Feldeffekttransistors (906);
   eine erste Messvorrichtung (510) zur Erfassung des Potenzialverlaufs an der Steuerelektrode des ersten Feldeffekttransistors (106);
   eine zweite Messvorrichtung (914) zur Erfassung des Potenzials an der Steuerelektrode des zweiten Feldeffekttransistors (906);
   eine programmgesteuerte Anordnung (108), welche dazu ausgebildet ist, im Betrieb folgende Schritte auszuführen:

   Bei einem Kommutierungsvorgang wird die Steuerelektrode desjenigen der beiden Feldeffekttransistoren (106, 906), welcher im Augenblick leitend gesteuert ist, auf hochohmig geschaltet;
   durch die diesem Feldeffekttransistor zugeordnete Messvorrichtung (510, 914) wird der Potenzialverlauf an der Steuerelektrode (G) erfasst;
   nachdem dieses Potenzial einen vorgegebenen Ausschaltgrad (A) des zugeordneten Feldeffekttransistors erreicht hat, wird der Steuerelektrode des anderen Feldeffekttransistors von der diesem zugeordneten Quelle (112, 510) für Steuersignale ein Einschaltsignal (VT1=1 oder VT2=1) für den anderen Feldeffekttransistor zugeführt.

2. Motor nach Anspruch 1, welcher einen Strombegrenzungswiderstand (116) aufweist, welcher zwischen einer Quelle (112, 912) von Steuersignalen und dem zugeordneten Feldeffekttransistor angeordnet ist, und welcher dazu dient, diesem Feldeffekttransistor ein Steuersignal zuzuführen.

3. Motor nach Anspruch 2, welcher einen Ableitwiderstand (118) aufweist, der zwischen Steuerelektroden eines Feldeffekttransistors angeordnet ist und dazu dient, beim Ausschalten den Strom durch diesen Feldeffekttransistor nach einer vorgegebenen Gesetzmäßigkeit zu reduzieren.

4. Motor nach Anspruch 3, bei welchem der Widerstand des Ableitwiderstands (118) größer ist als der Widerstand des Strombegrenzungswiderstand (116).

5. Motor nach Anspruch 3 oder 4, bei welchem der GATE-Anschluss des Feldeffekttransistors mit dem Strombegrenzungswiderstand und einem Anschluss des Ableitwiderstands verbunden ist, der Source-Anschluss und das andere Ende des Ableitwiderstands miteinander verbunden sind, und der Drain-Anschluss mit dem zugeordneten Wicklungsstrang verbunden ist.

6. Motor nach einem der vorhergehenden Ansprüche, bei welchem zwischen dem Gate-Anschluss und dem Drain-Anschluss des Feldeffekttransistors (106) ein RC-Glied (120, 122) vorgesehen ist.

7. Motor nach einem der vorhergehenden Ansprüche, bei welchem der Ausgang (110) einer Quelle von Steuersignalen zumindest beim Ausschalten des zugeordneten Feldeffekttransistors (106) als Mess-Eingang umschaltbar ist, welcher dazu ausgebildet ist, den Ausschaltgrad (A) des zugeordneten Feldeffekttransistors zu messen.

8. Motor nach Anspruch 7, bei welchem der Quelle (108) von Steuersignalen ein Komparator (114) zugeordnet ist, welcher dazu ausgebildet ist, ein Rückkopplungssignal mit einem Schaltschwellenwert (A) zu vergleichen, um den Ausschaltgrad des zugeordneten Feldeffekttransistors zu bestimmen.

**9.** Motor nach einem der vorhergehenden Ansprüche, bei welchem die programmgesteuerte Anordnung (108) dazu ausgebildet ist, den zweiten Feldeffekttransistor (906) einzuschalten, wenn der erste Feldeffekttransistor (106) ausgeschaltet ist, und auszuschalten, wenn der erste Feldeffekttransistor eingeschaltet ist.

**10.** Motor nach Anspruch 9, bei welchem die erste Quelle (900) von Steuersignalen zumindest beim Ausschalten des ersten Feldeffekttransistors als Mess-Eingang umschaltbar ist, welcher dazu ausgebildet ist, ein Motorsignal zu messen, welches den Ausschaltgrad des zugeordneten ersten Feldeffekttransistors kennzeichnet, die erste Quelle (108) einen Komparator (114) aufweist, der dazu ausgebildet ist, dieses Motorsignal mit einem Schaltschwellenwert (A) zu vergleichen, um den Ausschaltgrad des ersten Feldeffekttransistors zu bestimmen,
die erste Quelle ferner dazu ausgebildet ist, den zweiten Feldeffekttransistor (906) durch das zweite Steuersignal erst dann einzuschalten, wenn der Ausschaltgrad des ersten Feldeffekttransistors anzeigt, dass letzterer ausgeschaltet ist.

**11.** Motor nach Anspruch 9 oder 10, welcher eine Mehrzahl von Strombegrenzungswiderständen (116, 916) aufweist, wobei jeder Strombegrenzungswiderstand zwischen einem bestimmten Halbleiterschalter und dem diesem zugeordneten Ausgang der Steuereinheit angeordnet ist und dazu dient, dem bestimmten Halbleiterschalter das entsprechende Steuersignal zuzuführen.

## Claims

**1.** Electronically commutated motor, having:

a permanently magnetic rotor (960);
a stator with a first winding phase (102), with which a first field effect transistor (106), the purpose of which in operation is to control the current through the first winding phase (102) under the control of a potential at a control electrode (G), is associated;
a second winding phase (902), with which a second field effect transistor (906), the purpose of which in operation is to control the current through the second winding phase (102) under the control of a potential at a control electrode (G), is associated, and in operation the first field effect transistor (106) and second field effect transistor (906) are switched on alternately under the control of commutation events;
a first source (112, 510) of control signals (VT1, 1202), to control the first field effect transistor (106);
a second source (912, 914) of control signals (VT2, 1204), to control the second field effect transistor (906);
a first measuring device (510), to capture the potential course at the control electrode of the first field effect transistor (106);
a second measuring device (914), to capture the potential at the control electrode of the second field effect transistor (906);
a program-controlled arrangement (108), which is in a form to carry out the following steps in operation:

in the case of a commutation event, the control electrode of that one of the two field effect transistors (106, 906) which is conducting at that instant is switched to high resistance;
the measuring device (510, 914) associated with this field effect transistor captures the potential course at the control electrode (G);
after this potential has reached a predetermined degree of switching off (A) of the associated field effect transistor, a switching-on signal (VT1 = 1 or VT2 = 1) for the other field effect transistor is fed to the control electrode of the other field effect transistor from the source (112, 510) associated with it for control signals.

**2.** Motor according to Claim 1, having a current limiting resistor (116), which is arranged between a source (112, 912) of control signals and the associated field effect transistor, and which is used to feed a control signal to this field effect transistor.

**3.** Motor according to Claim 2, having a discharge resistor (118), which is arranged between control electrodes of a field effect transistor, and is used on switching off to reduce the current through this field effect transistor according to a predetermined regularity.

**4.** Motor according to Claim 3, wherein the resistance of the discharge resistor (118) is greater than the resistance of the current limiting resistor (116).

5. Motor according to Claim 3 or 4, wherein the GATE terminal of the field effect transistor is connected to the current limiting resistor and to one terminal of the discharge resistor, the source terminal and the other end of the discharge resistor are connected to each other, and the drain terminal is connected to the associated winding phase.

6. Motor according to one of the preceding claims, wherein between the gate terminal and the drain terminal of the field effect transistor (106), an RC element (120, 122) is provided.

7. Motor according to one of the preceding claims, wherein the output (110) of a source of control signals, at least when the associated field effect transistor (106) is switched off, can be switched as a measurement input, which is in a form to measure the degree of switching off (A) of the associated field effect transistor.

8. Motor according to Claim 7, wherein the source (108) of control signals is associated with a comparator (114), which is in a form to compare a negative feedback signal with a switch threshold value (A), to determine the degree of switching off of the associated field effect transistor.

9. Motor according to one of the preceding claims, wherein the program-controlled arrangement (108) is in a form to switch the second field effect transistor (906) on when the first field effect transistor (106) is switched off, and off when the first field effect transistor is switched on.

10. Motor according to Claim 9, wherein the first source (900) of control signals, at least when the first field effect transistor is switched off, can be switched as a measurement input, which is in a form to measure a motor signal which characterizes the degree of switching off of the associated first field effect transistor, the first source (108) has a comparator (114), which is in a form to compare this motor signal with a switch threshold value (A), to determine the degree of switching off of the first field effect transistor, and the first source is also in a form to switch the second field effect transistor (906) on by the second control signal only when the degree of switching off of the first field effect transistor indicates that the latter is switched off.

11. Motor according to Claim 9 or 10, having multiple current limiting resistors (116, 916), each current limiting resistor being arranged between a predetermined semiconductor switch and the control unit output associated with it, and being used to feed the corresponding control signal to the predetermined semiconductor switch.

**Revendications**

1. Moteur à commutation électronique, lequel présente :

   un rotor à aimant permanent (960) ;
   un stator avec un premier enroulement de phase (102), auquel est associé un premier transistor à effet de champ (106) qui sert, commandé par un potentiel à une électrode de commande (G), à commander, en fonctionnement, le courant à travers le premier enroulement de phase (102) ;
   un deuxième enroulement de phase (902), auquel est associé un deuxième transistor à effet de champ (906) qui sert, commandé par un potentiel à une électrode de commande (G), à commander, en fonctionnement, le courant à travers le deuxième enroulement de phase (902), le premier transistor à effet de champ (106) et le deuxième transistor à effet de champ (906) étant, en fonctionnement, activés alternativement par des processus de commutation ;
   une première source (112, 510) de signaux de commande (VT1, 1202) pour la commande du premier transistor à effet de champ (106) ;
   une deuxième source (912, 914) de signaux de commande (VT2, 1204) pour la commande du deuxième transistor à effet de champ (906) ;
   un premier dispositif de mesure (510) pour saisir la variation de potentiel à l'électrode de commande du premier transistor à effet de champ (106) ;
   un deuxième dispositif de mesure (914) pour saisir la variation de potentiel à l'électrode de commande du deuxième transistor à effet de champ (906) ;
   un dispositif commandé par programme (108), lequel est conçu pour exécuter les étapes suivantes en fonctionnement :

lors d'un processus de commutation, l'électrode de commande de celui des deux transistors à effet de champ (106, 906) qui est actuellement conducteur est mise à haute impédance ;

la variation de potentiel à l'électrode de commande (G) est saisie par le dispositif de mesure (510, 914) associé à ce transistor à effet de champ ;

lorsque ce potentiel a atteint un degré de désactivation (A) prédéfini du transistor à effet de champ associé, un signal d'activation (VT1 = 1 ou VT = 2) pour l'autre transistor à effet de champ est amené à l'électrode de commande de l'autre transistor à effet de champ par la source (112, 510) de signaux de commande associée à celui-ci.

2. Moteur selon la revendication 1, lequel présente une résistance de limitation de courant (116), laquelle est disposée entre une source (112, 912) de signaux de commande et le transistor à effet de champ associé, et laquelle sert à amener un signal de commande à ce transistor à effet de champ.

3. Moteur selon la revendication 2, lequel présente une résistance de dérivation (118) qui est disposée entre des électrodes de commande d'un transistor à effet de champ et qui sert, lors de la désactivation, à réduire selon une loi prédéfinie le courant à travers ce transistor à effet de champ.

4. Moteur selon la revendication 3, dans lequel la résistance de la résistance de dérivation (118) est supérieure à la résistance de la résistance de limitation de courant (116).

5. Moteur selon la revendication 3 ou 4, dans lequel la connexion de grille du transistor à effet de champ est reliée à la résistance de limitation de courant et à une connexion de la résistance de dérivation, la connexion de source et l'autre côté de la résistance de dérivation sont reliées ensemble, et la connexion de drain est reliée à l'enroulement de phase associé.

6. Moteur selon une des revendications précédentes, dans lequel un circuit RC (120, 122) est prévu entre la connexion de grille et la connexion de drain du transistor à effet de champ (106).

7. Moteur selon une des revendications précédentes, dans lequel la sortie (110) d'une source de signaux de commande est commutable, au moins lors de la désactivation du transistor à effet de champ (106) associé, en entrée de mesure conçue pour mesurer le degré de désactivation du transistor à effet de champ associé.

8. Moteur selon la revendication 7, dans lequel à la source (108) de signaux de commande est associé un comparateur (114), lequel est conçu pour comparer un signal de rétroaction avec une valeur seuil de commutation (A) pour déterminer le degré de désactivation du transistor à effet de champ associé.

9. Moteur selon une des revendications précédentes, dans lequel le dispositif commandé par programme (108) est conçu pour activer le deuxième transistor à effet de champ (906) quand le premier transistor à effet de champ (106) est désactivé et à le désactiver quand le premier transistor à effet de champ est activé.

10. Moteur selon la revendication 9, dans lequel la première source (900) de signaux de commande est commutable, au moins lors de la désactivation premier du transistor à effet de champ, en entrée de mesure conçue pour mesurer un signal de moteur qui caractérise le degré de désactivation du premier transistor à effet de champ associé, la première source (108) présente un comparateur (114) qui est conçu pour comparer ce signal de moteur avec une valeur seuil de commutation (A) pour déterminer le degré de désactivation du premier transistor à effet de champ, la première source est en outre conçue pour activer le deuxième transistor à effet de champ (906) seulement lorsque le degré de désactivation du premier transistor à effet de champ indique que ce dernier est désactivé.

11. Moteur selon la revendication 9 ou 10, lequel présente une pluralité de résistances de limitation de courant (116, 916), chaque résistance de limitation de courant étant disposée entre un commutateur à semiconducteurs défini et la sortie associée à celui-ci de l'unité de commande, et sert à amener le signal de commande correspondant au commutateur à semiconducteurs défini.

Fig. 1

FIG. 2

Fig. 3

FIG. 4

Fig. 5

FIG. 6

```
              ┌─────────────┐
              │    Start    │────S1402
              └─────────────┘
                     │
                     ▼         ─S1404
         ┌──────────────────────┐
    ┌───▶│      VT1 = 1         │
    │    └──────────────────────┘
    │                │    ─S1406
    │    ┌──────────────────────┐
    │    │    VT1 = Tristate     │
    │    └──────────────────────┘
    │                │    ─S1408
    │    ┌──────────────────────┐
    │ ┌─▶│    VT1 = Tristate     │
    │ │  │       U_GS = ?        │
    │ │  └──────────────────────┘
    │ │             │      ─S1410
    │ │          ◇ U_GS = A ?  ◇  Y
    │ │  N
    │ └────────
    │
    └──────────────────────────
```

```
                         ─S1412
         ┌──────────────────────┐
    ───▶ │      VT2 = 1         │
         └──────────────────────┘
                    │    ─S1414
         ┌──────────────────────┐
         │    VT2 = Tristate     │
         └──────────────────────┘
                    │    ─S1416
         ┌──────────────────────┐
     ┌──▶│    VT2 = Tristate     │
     │   │       U_GS = ?        │
     │   └──────────────────────┘
     │              │      ─S1418
     │           ◇ U_GS = A ?  ◇  N
     │   Y
     └────────
```

FIG. 7

**EP 1 797 634 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20040051489 A